(19) Europäisches Patentamt
European Patent Office
Office européen des brevets

(11) **EP 4 550 673 A1**

(12) **EUROPEAN PATENT APPLICATION**

(43) Date of publication:
07.05.2025 Bulletin 2025/19

(21) Application number: 24206460.8

(22) Date of filing: 14.10.2024

(51) International Patent Classification (IPC):
**H04B 1/12** $^{(2006.01)}$

(52) Cooperative Patent Classification (CPC):
**H04B 1/123**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 31.10.2023 US 202318499108

(71) Applicant: Avago Technologies International
Sales
Pte. Limited
Singapore 768923 (SG)

(72) Inventors:
• **Yang, Xiaochen**
**Irvine, 92618 (US)**

• **Liu, Yong**
**Irvine, 92618 (US)**
• **Liu, Renfei**
**Irvine, 92618 (US)**
• **Wang, Chifeng**
**Irvine, 92618 (US)**
• **Cui, Delong**
**Irvine, 92618 (US)**
• **Cao, Jun**
**Irvine, 92618 (US)**

(74) Representative: **Bosch Jehle
Patentanwaltsgesellschaft mbH
Flüggenstraße 13
80639 München (DE)**

(54) **METHOD AND SYSTEM FOR DIGITAL NON-LINEARITY COMPENSATION**

(57) In some implementations, the circuitry may include a circuit configured to receive a baseband signal, the baseband signal having an intermodulated non-linear distorted portion and a harmonic distorted portion. In addition, the circuitry may include a compensator coupled to the circuit, the compensator configured to generate a value to compensate for the intermodulated non-linear distorted portion without compensating for the harmonic distorted portion. The circuitry may include where the compensator is configured to output the value. The circuitry may include where the circuit is configured to adjust the baseband signal using the value. In some embodiments, the baseband signal can be baseband voltage. In some embodiments, the value can be a complex number.

EP 4 550 673 A1

**Description**

The present disclosure relates generally to the field of non-linearity compensation of a signal receiver, and more specifically to the non-linearity compensation in a digital baseband of the receiver.

A wireless base station receiver often requires high linearity. The linearity can be achieved through higher power consumption and larger transistor size in analog circuits, which can result in significant power consumption and demanding reliability requirements. As the standards evolve in 5G, 6G, and Next-G, satisfying substantial power consumption and reliability requirements becomes more difficult. It is desirable to have a relatively simple digital approach that can leverage digital processing power to achieve the relatively high linearity required by the receiver.

A digital non-linearity compensation in the wireless base station receiver primarily focuses on radio frequency (RF) band compensation. An RF analog-to-digital converter (ADC) has a high-sampling rate, causing a relatively high power consumption. Moreover, receiver non-linearity over frequency presents significant magnitude and phase variation. To be valid at high frequency, such magnitude and phase variation often require extensive corrective terms, further increasing the digital processing power.

The wireless base station receiver can have an anti-aliasing filter. Such filter suppresses high frequency harmonic distortion but preserves in-band intermodulation distortion, making these two non-linearity components uncorrelated. Therefore, it makes it difficult for non-linearity compensation techniques in the analog or digital RF band to handle these two types of distortion simultaneously, e.g., compensating one without affecting the other. Analog or digital RF band approaches for compensation will generate corrective terms both for harmonic distortion and intermodulation distortion at the same time.

When intermodulated distortion (IMD) and harmonic distortion are present in a signal, it becomes more challenging to analyze the distortion because these two types of distortion interact with each other. For instance, the presence of IMD can introduce new frequencies that might, in turn, become sources of harmonic distortion. This interplay of two distortions complicates the identification and measurement of distortion components within the signal.

The interaction between IMD and harmonic distortion can lead to the generation of unpredictable frequencies. This unpredictability makes it difficult to anticipate the nature and location of distortion components within the signal spectrum. Complex mathematical models and simulations can be often required to understand and predict these effects accurately.

To mitigate mixed IMD and harmonic distortion in a nonlinear system effectively, sophisticated signal processing techniques can be implemented, such as adaptive filters and digital predistortion. These techniques aim to reduce or eliminate the unwanted components generated by nonlinearities. However, optimizing these methods for specific applications can be a time-consuming and resource-intensive process.

It is desirable to have a compensation scheme that only focuses on one distortion, for example, the intermodulation distortion, which can be a main distortion requirement for RF applications.

A digital non-linearity compensation described herein can be used for a direct sampling basestation receiver. Instead of or in addition to analog non-linearity compensation or digital compensation in the RF band, the non-linearity compensation in a digital baseband can be used. In some embodiments, the non-linearity compensation in the digital baseband can provide significant power saving. Raw baseband input (e.g., raw voltage) can be computed in the baseband to generate non-linearity corrective term (e.g., calibration voltage). An output (e.g., final voltage) can be a summation of the raw baseband input and the non-linearity corrective term. The corrective term can be calculated using a preset non-linearity coefficient along with a third order multiplication of an input in-phase and quadrature (I/Q) data. The corrective term can include only intermodulated non-linearity content and does not have direct harmonic distortion of the raw baseband input signal. Such configuration can provide the baseband non-linearity compensation that includes compensation only to the intermodulated non-linearity of the input signal, without generating undesired harmonics for the input signal.

In one general aspect, a circuitry may include a circuit configured to receive a baseband signal where the baseband signal has an intermodulated non-linear distorted portion and a harmonic distorted portion. The circuitry may also include a compensator coupled to the circuit where the compensator is configured to generate a value to compensate for the intermodulated non-linear distorted portion without compensating for the harmonic distorted portion. The circuitry may furthermore include implementations where the compensator is configured to output the value. The circuitry may in addition include implementations where the circuit is configured to adjust the baseband signal using the value. Other embodiments of this aspect include corresponding computer systems, apparatus, and computer programs recorded on one or more computer storage devices, each configured to perform the actions of the methods.

Implementations may include one or more of the following features. The circuitry may include implementations where the baseband signal is a baseband voltage. The circuitry may include implementations where the value is a complex number, which may include an in-phase portion of the baseband signal and a quadrature portion of the baseband signal. The circuitry may include implementations where the compensator further includes at least one of a rounding or truncation engine to output the value where the value is rounded or truncated. The circuitry may include implementations where a dither is injected before the rounding or truncation engine. The circuitry may include implementations where the value is based at least on the baseband signal, a square of an absolute value of the baseband signal, and a non-linearity coefficient. The circuitry may include implementations where one or more values of the non-linearity coefficient are selected responsive to an operational frequency of the baseband signal. The circuitry may include a down converter to filter mirror frequencies. Implementations of the described techniques may include hardware, a method or process, or a computer tangible medium.

In one general aspect, a system may include a device that may be configured to receive a baseband signal where the baseband signal has an intermodulated non-linear distorted portion and a harmonic distorted portion. The system may include a compensator configured to generate a value to compensate for the intermodulated non-linear distorted portion without compensating for the harmonic distorted portion. The system may include implementations where the device is configured to adjust the baseband signal using the value provided by the compensator.

The system may include implementations where the baseband signal is a baseband voltage. The system may include implementations where the value is a complex number, which includes an in-phase portion of the baseband signal and a quadrature portion of the baseband signal. The system may include implementations where the compensator further includes at least one of a rounding or truncation engine to output the value where the value is rounded or truncated. The system may include implementations where a dither is injected before the rounding or truncation engine. The system may include implementations where the value is based at least on the baseband signal, a square of an absolute value of the baseband signal, and a non-linearity coefficient. The system may include implementations where one or more values of the non-linearity coefficient are selected responsive to an operational frequency of the baseband signal.

In one general aspect, a method may include receiving by a circuit a baseband signal where the baseband signal has an intermodulated non-linear distorted portion and a harmonic distorted portion. The method may also include generating, by a compensator coupled to the circuit, a value to compensate for the intermodulated non-linear distorted portion without compensating for the harmonic distorted portion. The method may furthermore include adjusting, by the circuit, the baseband signal using the value outputted by the compensator. Other embodiments of this aspect include corresponding computer systems, apparatus, and computer programs recorded on one or more computer storage devices, each configured to perform the actions of the methods.

The method may include implementations where the baseband signal is a baseband voltage. The method may include implementations where the value is a complex number, which has an in-phase portion of the baseband signal and a quadrature portion of the baseband signal. The method may further include injecting a dither to the compensator. The method may further include at least one of rounding or truncating the value. The method may include implementations where the value is based at least on the baseband signal, a square of an absolute value of the baseband signal, and a non-linearity coefficient. The method may further include selecting one or more values of the non-linearity coefficient responsive to an operational frequency of the baseband signal. The method may further include filtering, by a down converter, mirror frequencies from the baseband signal. According to an aspect, a circuitry is provided comprising:

a circuit configured to receive a baseband signal, the baseband signal having an intermodulated non-linear distorted portion and a harmonic distorted portion; and
a compensator coupled to the circuit, the compensator configured to generate a value to compensate for the intermodulated non-linear distorted portion without compensating for the harmonic distorted portion, wherein the compensator is configured to output the value, and wherein the circuit is configured to adjust the baseband signal using the value.

Advantageously, the baseband signal is a baseband voltage.

Advantageously, the value is a complex number further comprising an in-phase portion of the baseband signal and a quadrature portion of the baseband signal.

Advantageously, the compensator further comprises:

at least one of a rounding or truncation engine to output the value,
wherein the value is rounded or truncated, and
wherein a dither is injected before the rounding or truncation engine.

Advantageously, the value is based at least on the baseband signal, a square of an absolute value of the baseband signal, and a non-linearity coefficient.

Advantageously, one or more values of the non-linearity coefficient are selected responsive to an operational frequency of the baseband signal.

Advantageously, the circuitry further comprises:
a down converter to filter mirror frequencies.

According to an aspect, a system is provided comprising:
a device configured to receive a baseband signal, the baseband signal having an intermodulated non-linear distorted portion and a harmonic distorted portion, the system comprising: a compensator configured to generate a value to compensate for the intermodulated non-linear distorted portion without compensating for the harmonic distorted portion, wherein the device is configured to adjust the baseband signal using the value provided by the compensator.

Advantageously, the baseband signal is a baseband voltage.

Advantageously, the value is a complex number further comprising an in-phase portion of the baseband signal and a quadrature portion of the baseband signal.

Advantageously, the compensator further comprises:

at least one of a rounding or truncation engine to output the value,
wherein the value is rounded or truncated, and
wherein a dither is injected before the rounding or truncation engine.

Advantageously, the value is based at least on the baseband signal, a square of an absolute value of the baseband signal, and a non-linearity coefficient.

Advantageously, one or more values of the non-linearity coefficient are selected responsive to an operational frequency of the baseband signal.

According to an aspect, a method is provided comprising:

receiving, by a circuit, a baseband signal, the baseband signal comprising an intermodulated non-linear distorted portion and a harmonic distorted portion;
generating, by a compensator coupled to the circuit, a value to compensate for the intermodulated non-linear distorted portion without compensating for the harmonic distorted portion; and adjusting, by the circuit, the baseband signal using the value outputted by the compensator.

Advantageously, the baseband signal is a baseband voltage.

Advantageously, the value is a complex number further comprising an in-phase portion of the baseband signal and a quadrature portion of the baseband signal.

Advantageously, the method further comprises:

injecting a dither to the compensator;
at least one of rounding or truncating the value.

Advantageously, the value is based at least on the baseband signal, a square of an absolute value of the baseband signal, and a non-linearity coefficient.

Advantageously, the method further comprises selecting one or more values of the non-linearity coefficient responsive to an operational frequency of the baseband signal.

Advantageously, the method further comprises: filtering, by a down converter, mirror frequencies from the baseband signal.

BRIEF DESCRIPTION OF THE DRAWINGS

FIG. 1 is a system for digital baseband non-linearity compensation, according to some embodiments.

FIG. 2 illustrates the digital baseband non-linearity compensation when a baseband signal is a one-tone signal, according to some embodiments.

FIG. 3 illustrates the digital baseband non-linearity compensation when a baseband signal is a two-tone signal, according to some embodiments.

FIG. 4 illustrates a magnitude and a phase of a non-linearity coefficient for different frequencies, according to some embodiments.

FIGS. 5A-5B illustrate a linearity performance improvement of a digital non-linearity compensation using a two-tone test, according to some embodiments.

FIGS. 6A-6B illustrate a linearity performance improvement of a digital non-linearity compensation using a wide-band simulation, according to some embodiments.

FIG. 7 illustrates a digital baseband non-linearity compensation system having a dither and rounding or truncation operation, according to some embodiments.

FIG. 8A illustrates an output of the digital baseband non-linearity compensation system without adding the dither, according to some embodiments.

FIG. 8B illustrates an output of the digital baseband non-linearity compensation system when the dither is added, according to some embodiments.

FIG. 9 is a flowchart of an example process for digital baseband non-linearity compensation.

FIGS. 10A and 10B depict block diagrams of a computing device useful for practicing an embodiment of the client device or network device, according to some embodiments.

FIG. 10C depicts an embodiment of a computing device in which the processor communicates directly with main memory via a memory port, according to some embodiments.

DETAILED DESCRIPTION

In analog non-linearity compensation for RF analog-to-digital conversion an input buffer can be utilized. The non-linearity of high-speed RF analog-to-digital conversion used in wireless receivers mostly comes from the analog front-end, such as a programmable gain amplifier or an input buffer. To improve linearity, analog circuit non-linearity (e.g., gain compression) can be compensated with an inverse characteristic (e.g., gain expansion). For example, correcting the input buffer non-linearity can include a push-pull (PP) follower topology and harmonic-compensated-diode-load (HC-DL). In a push-pull configuration, there are two transistors - one transistor actively pulling up the signal and the other transistor actively pulling down the signal. This arrangement enhances the buffer's ability to drive the output while reducing distortion and improving linearity. An intrinsic characteristic or gain compression of PP-follower topology results in non-linearity of, e.g., Iout over Vin. An inverse characteristic or gain expansion of HC-DL is utilized for compensation.

The input buffer is biased through passive level shifters (LSs). Level shifters are circuit components that adjust the voltage level of the input signal. The LSs enable the input signal to be at the appropriate voltage level for the subsequent stages of the ADC. For example, if the subsequent stages are programmed to anticipate a voltage range of 0-1V and the input signal is at 0.5-1.5V, passive level shifters can bring it within the desired range. Passive LSs may not consume a significant amount of power. HC-DL suppresses non-linearity in the buffer. HC-DL mitigates the non-linearity by compensating for harmonics in the signal, which can contribute to non-linearity. The harmonics are undesired frequency components that can cause deviations from the ideal linear response. By suppressing the harmonics, the HC-DL helps improve the linearity of the input buffer. Biasing is a technique used to set a stable operating point for various components within a circuit. Biasing involves setting a fixed voltage or current to stabilize the operation of components within the circuit. Biasing ensures that the components of the circuit work within their desired and linear operating ranges. The bias voltage for the HC-DL, represented as voltage bias for HC-DL positive terminal (VBIP) and voltage bias for HC-DL negative terminal (VBIN), are determined by a calibration engine. The calibration engine is responsible for adjusting and fine-tuning the bias voltages VBIP and VBIN. This adjustment process may be carried out using feedback mechanisms and algorithms.

One of the drawbacks of such analog non-linearity compensation is that not all analog circuits have a mechanism that can be used for compensation by using the inverse characteristic. Also, such compensation often has limited effectiveness in terms of accuracy and high frequency operation.

Another technique for non-linearity compensation can be performed in the digital RF band. For example, an RF analog-to-digital conversion with non-linearity compensation can be performed in the RF band. High-speed RF data captured from the RFADC is directly processed and compensated by the non-linearity digital block in the RF band. Such method can be performed in a conventional RFADC. A digital non-linearity correction block can be inserted at the output of high-speed data transmission before a multi-bit captured data (e.g., baseband signal) is received by the baseband circuitry. But such digital processing for non-linearity correction may often require high-speed data processing for the captured multi-bit data in real or near real time. This may result in significant power consumption when the wireless standards develop for Next-G and sampling rate of RF analog-to-digital conversion becomes higher.

A baseband signal is an electronic signal that retains the original information or data being transmitted without alteration or conversion. It originates from a source such as a microphone or a computer and travels through a transmission medium like a cable or a wireless network. The baseband signal may be modulated or converted into another signal type, such as a carrier or wireless signal, to be transmitted over long distances or various media. Baseband voltage refers to the original, unmodulated voltage signal that directly represents the information or data being transmitted.

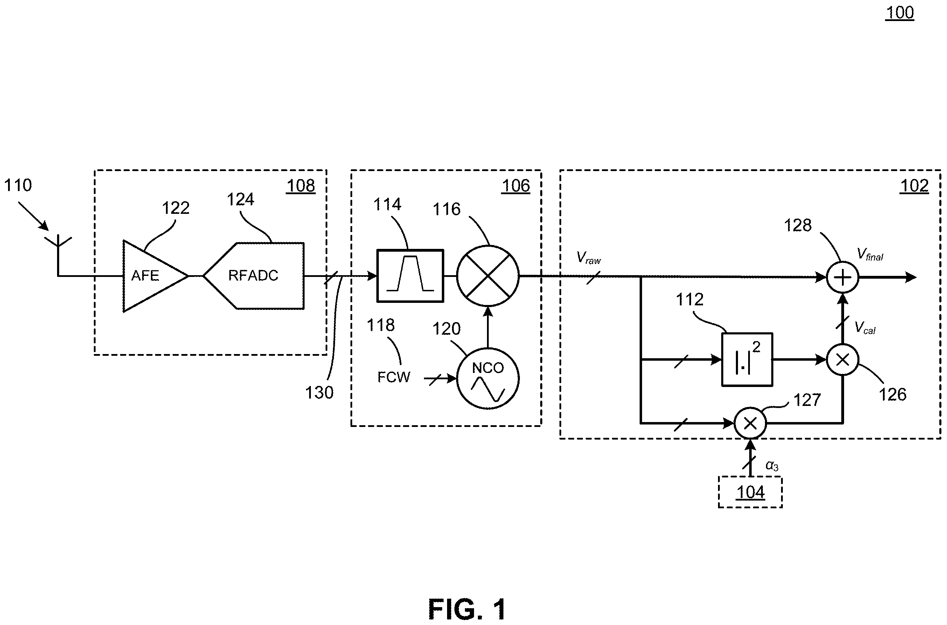

FIG. 1 illustrates a system 100 for digital non-linearity compensation, according to some embodiments. In some embodiments, the system 100 can include a baseband circuitry 102 and a circuitry 106 that is external to the baseband circuitry 102. In some embodiments, the system 100 can include a receiving circuitry 108 that receives an analog signal from a receiving antenna 110. A direct sampling basestation receiver can have a digital non-linearity compensation that can be performed in the baseband circuitry 102.

In some embodiments, the system 100 can include a circuitry 108 that includes an analog receiver 122 and a digitizer 124. For example, the circuitry 108 can include an analog front-end (AFE) module 122 and analog-to-digital converter (ADC) 124 (that can be an RF ADC). AFE 122 is the interface between the analog and digital domains, substantially bridging the gap between physical signals and the digital processing circuitry. In some embodiments, the RFADC 124 converts analog signal received by the circuitry 108.

In some embodiments, the circuitry 106 can include a digital RF band circuit that enables transmitting digital signals wirelessly. For example, the digital RF band enables converting digital signals into radio waves that can be transmitted over the air. The digital baseband circuitry 102, on the other hand, processes the digital signals and prepares them for transmission through the circuitries 106 and 108. The circuitries 106 and 108 enable transmission and receipt of information wirelessly, without needing to be physically coupled to one another.

The digital RF band circuit of the circuitry 106 can include a down-converter. The down-converter is a component that reduces the frequency of an input signal, from a higher RF frequency to a lower intermediate frequency (IF) or a baseband frequency. The operation of a down-converter involves mixing the input RF signal with a local oscillator (LO) signal. The mixer generates output signals at the sum and difference frequencies of the input and LO signals. By selecting the LO frequency, the down-converter can shift the input signal frequency to the desired lower frequency range. Such frequency translation can enable extracting information from the RF signals and making the RF signals more manageable for subsequent processing.

The down-converter can include a band-pass filter (BPF) 114, a mixer (or multiplier) 116, and an oscillator 120. A filter is a device or technique used to selectively remove or alter certain components of a signal. Filters can be used to separate or attenuate different frequencies of signals, leading to cleaner and clearer signals. Filters can be low-pass, high-pass, band-pass, and band-stop filters, for instance. Low-pass filters allow low-frequency components of a signal to pass through and attenuate high-frequency components. High-pass filters do the opposite, allowing high-frequency components to pass through and attenuating low-frequency components. Band-pass filters only allow a certain band of frequencies to pass through, while attenuating both lower and higher frequencies. Band-stop filters or notch filters, attenuate a certain band of frequencies while allowing other frequencies to pass through. Filters can be implemented using various techniques, including analog and digital circuits, as well as software algorithms.

The oscillator 120 can be a nonlinear crystal oscillator (NCO). The circuitry 106 can include a frequency control word (FCW) module 118. The FCW is a digital word or value that can be used to configure the frequency of an oscillator or a signal generator, facilitating setting, adjusting, and control of the output frequency with higher precision. A signal 130 is received by the BPF 114 from the RFADC 124, the BPF 114 allows signals within a specified frequency range to pass through to the mixer 116 while attenuating frequencies outside of that range. The NCO 120 can receive an FCW 118 and send a signal to the mixer 116 that mixes the signals received from the BPF 114 and the NCO 120. An output of the mixer 116 is a signal $V_{raw}$ that is sent to the digital baseband circuit 102.

The digital non-linearity compensation for a direct sampling basestation receiver is achieved by performing a non-linearity compensation in the baseband circuit 102 instead of using the RF band circuit 106. In some embodiments, the system 100 can include a digital baseband non-linearity compensation engine 104 that determines a non-linearity coefficient a3 (or $\alpha_3$) and provides a3 to the digital baseband circuit 102. The baseband circuit 102 can include a plurality of operators that perform addition and multiplication functions.

In some embodiments, the signal $V_{raw}$ (that can be, e.g., voltage) can be received by the digital baseband circuit 102 from the mixer 116 of the circuit 106. In some embodiments, $V_{raw}$ is provided below as an illustrative example.

$$V_{raw} = I + j \times Q$$

"I" and "Q" represent the in-phase and quadrature components of the signal $V_{raw}$, respectively. The In-phase component (I) represents the part of the signal that is in-phase with a reference signal, such as a carrier wave. This component carries the amplitude and phase information of the original signal. The Quadrature component (Q) represents the part of the signal that is 90 degrees out of phase with the In-phase component. Q carries information about the phase difference between the original signal and the reference signal. The variable "$j$" represents the imaginary unit, which is defined as the square root of -1. I and Q components are used to represent a signal in a complex plane.

A binary addition can involve a series of logic gates in the form of a ripple-carry adder. For example, an "addition array" can be an arrangement of logic gates and components that collectively perform binary addition for multi-bit operands. In some embodiments, hardware multipliers perform binary multiplication using an array of logic gates, such as in the form of an array multiplier. The array multiplier breaks down multiplication into multiple AND and XOR gates. In some embodiments, each bit of one operand is multiplied with each bit of the other operand; the partial products are then added together to form the final result.

As FIG. 1 shows, raw baseband inputs are computed in the baseband circuit 102 to generate non-linearity corrective term, Veal. At a multiplication operator 127, the signal $V_{raw}$ undergoes an operation of multiplying a value of the signal $V_{raw}$ by the non-linearity coefficient $\alpha_3$. An output $\alpha_3 \times (I + j \times Q)$ of the multiplicator 112 is fed into the multiplication operator 126. At a multiplication operator 112, the signal $V_{raw}$ undergoes an operation of multiplying an absolute value of the signal $V_{raw}$ by itself. Absolute value refers to a mathematical concept used to represent the magnitude or distance of a number from zero, regardless of the sign (positive or negative) of the number. The absolute value of a number is always positive or zero. The absolute value is useful for comparing the sizes of numbers or for simplifying equations where negative numbers are involved.

An output $V_{raw} |I + j \times Q|^2$ of the multiplicator 112 is fed into the multiplication operator 126. The multiplication operator 126 multiplies the outputs of the multiplicators 112 and 127 to output the $V_{cal}$. In some embodiments, $V_{cal}$ is provided below as an illustrative example.

$$V_{cal} = \alpha_3 \times (I + j \times Q) \times |I + j \times Q|^2$$

Vcal is calculated through a preset non-linearity coefficient, a3, together with a third order multiplication of input I/Q data. Vcal includes an intermodulated non-linearity content and does not include a direct harmonic distortion of the input signal Vraw. Having only intermodulated non-linearity content of the signal Vraw and not having a direct harmonic distortion enables the baseband non-linearity compensation being performed only to the intermodulated non-linearity of the signal Vraw, without generating extra undesired harmonics for the signal Vraw.

An addition operator 128 adds the signals $V_{raw}$ and $V_{cal}$ and outputs a signal $V_{final}$. The signal $V_{final}$ is the sum of Vraw and Vcal and is provided below as an illustrative example.

$$V_{final} = V_{raw} + V_{cal}$$

Compared with other RF band compensation, the compensation described in the present disclosure provides the following advantages: (1) significant power saving, (2) decoupling intermodulation and harmonic distortion, and (3) using complex operation (e.g., the imaginary unit $j$) to perform compensation enables compensation of the phase shift content of the IMD distortion. Phase shift refers to the delay or advance in the phase of a wave when it passes through a medium or encounters an obstacle. The phase shift is the amount by which a wave is shifted in time or space. The phase shift of a wave is measured in degrees or radians, and it can be either positive or negative, depending on the direction of the shift.

In some embodiments, the non-linearity compensation in the baseband circuit 102 provides a significant power saving because compensation is performed on the signal Vraw that underwent the down-conversion in the digital RF band circuit 106 after being processed by the analog receiver 122 and the digitizer 124 of the circuit 108.

In some embodiments, a compensator can refer to a combination of the digital baseband non-linearity compensation engine 104, the multiplicators 112, 126, 127, and the addition operator 128. A compensator is a device or mechanism that is designed to reduce or eliminate (compensate) the effects of disturbances or variations in a specific system. Compensators are used to improve the stability, accuracy, or performance of a system by adjusting or controlling the input or output signals. The compensator can be implemented as a feedback control system that corrects or compensates for errors or variations that occur in a system.

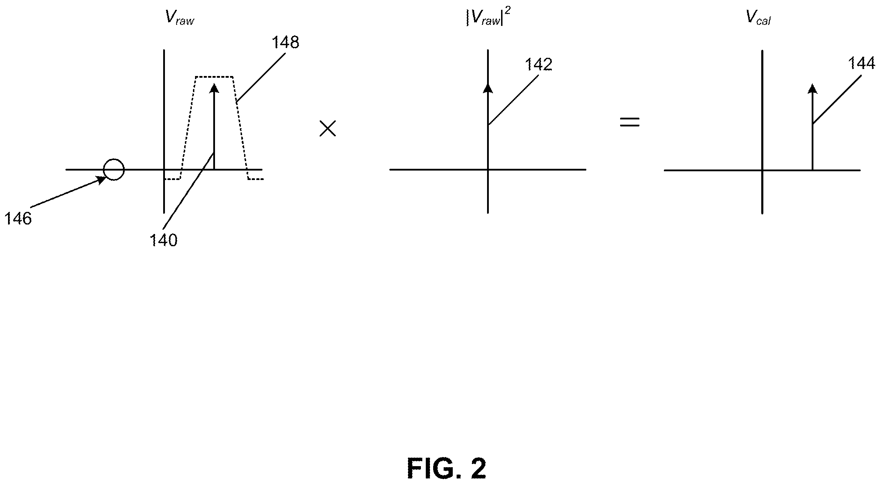

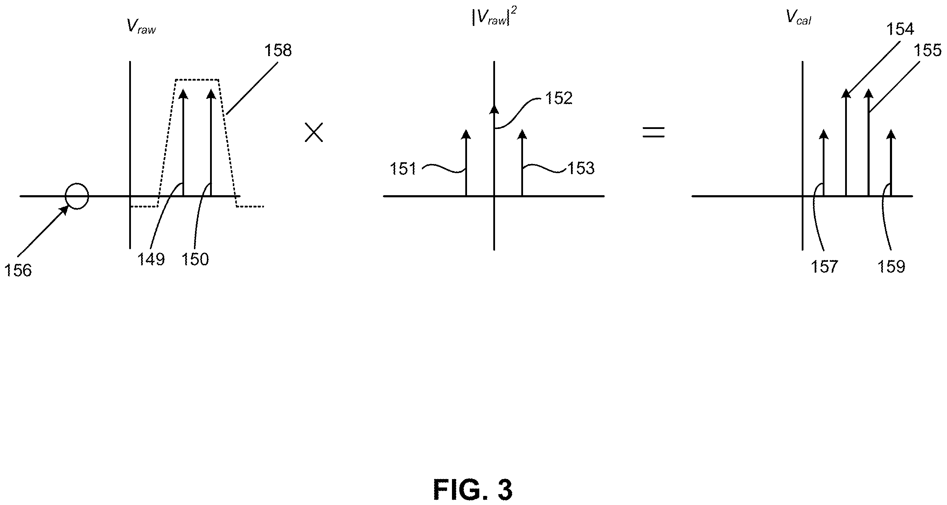

FIGS. 2 and 3 illustrate the digital baseband non-linearity compensation that compensates only intermodulation distortion and does not generate undesired harmonic distortion, according to some embodiments.

For RF application, in-band intermodulation distortion can be more important linearity specification than harmonic distortion, because RF application intrinsically is narrowband and harmonic distortion has other system approach for mitigation, e.g., filtering or frequency planning. In some embodiments, the system 100 focuses on mitigating intermodulation without affecting the harmonic distortion.

FIG. 2 illustrates the digital baseband non-linearity compensation for the signal Vraw that is a single-tone signal 140. The signal 140 undergoes a bandpass filter 148 (that is a component of a down-converter). Vraw can be represented by $I+j \times Q$ or $e^{jw}$, where $\omega$ is the frequency of the fundamental signal Vraw. There is substantially no mirror frequency 146 because the mirror frequency 146 is filtered out through the down-converter (of, e.g., the circuit 106).

Mirror frequencies refer to the phenomenon where two or more frequencies in a signal are reflections of each other around a certain center frequency. These frequencies have the same distance from the center frequency and are equidistant from each other. For example, in a communication system, mirror frequencies may occur when the transmitted signal is reflected by a surface and the reflected signal interferes with the original signal. This can cause distortion or attenuation of the signal and may lead to communication errors.

The fundamental frequency of a digital signal is the lowest frequency component of the signal and represents its fundamental tone or pitch. This frequency is determined by the rate at which the signal changes polarity, meaning it alternates between a positive and negative voltage. For example, a sine wave has a fundamental frequency equal to the frequency of the wave itself, which is the rate at which it oscillates between maximum positive and negative values. The fundamental frequency is often referred to as the clock rate or sampling rate, which is the rate at which the signal is sampled or measured.

A harmonic distorted portion is a phenomenon that occurs in electrical systems when the pure sinusoidal waveform of an alternating current (AC) is distorted or altered due to the presence of harmonic frequencies. Harmonic frequencies are multiples of the fundamental frequency of the AC waveform, and their presence in an electrical system can cause undesirable effects such as overheating of equipment, increased power losses, and reduced efficiency. Harmonic distortion can also lead to interference with other electronic devices and may cause disturbances in the power supply. The harmonic distorted portion is often measured as the total harmonic distortion (THD) of an AC signal, expressed as a percentage of the fundamental frequency. The THD represents the sum of the amplitudes of all harmonic frequencies present in the waveform relative to the amplitude of the fundamental frequency. If the THD is higher, the level of harmonic distortion in the AC signal can be greater.

An intermodulated non-linear distorted portion refers to a signal processing phenomenon that occurs when two or more signals are mixed together, and the resulting waveform contains components that were not present in the original signals. For example, when signals with different frequencies are combined, they may produce additional frequencies that were not present in the original signals. The non-linear distorted portion in intermodulation refers to the part of the resulting waveform that is due to the non-linear behavior of a signal processing system. Non-linear systems do not exhibit a linear relationship between input and output, therefore the output signal may not be proportional to the input signal. In the case of intermodulation distortion, the non-linear distorted portion of the waveform is caused by the system non-linear response to the input signals.

The signal $|Vraw|^2$ equals to $|I+j\times Q|^2$ or $|e^{j\omega}|^2$ that is equal to 1 because $|e^{j\omega}|^2$ equals to summation of $\cos^2\omega$ and $\sin2\omega$, where the summation equals to 1. As illustrated in FIG. 2, the RF down-converter in the baseband circuit 106 filters out the mirror frequency 146, so $|Vraw|^2$ (represented by a signal 142) does not have a frequency content $2\omega$ and Vcal does not have a frequency content $3\omega$, where $\omega$ is the frequency of the fundamental signal Vraw. The resulting compensation, the signal Vcal (represented by a signal 144), compensates intermodulation without affecting the harmonic distortion. The signal 144 is a right-shifted representation of the signal 142. In the one-tone signal 148, only the fundamental portion is present and there are no intermodulated portions in the signal 144, meaning that Vcal does not impact harmonic distortion.

FIG. 3 illustrates the digital baseband non-linearity compensation when Vraw is a two-tone signal 149, 150. The signal 149, 150 undergoes a bandpass filter 158 (that is a component of a down-converter). There is substantially no mirror frequency 156 because the mirror frequency 156 is filtered out through the down-converter (of, e.g., the circuit 106).

As illustrated in FIG. 3, the RF down-converter in the baseband circuit 106 filters out the mirror frequency 156, so $|Vraw|^2$ (represented by a signal 151, 152, 153) does not have a frequency content $2\omega$ and Veal does not have a frequency content $3\omega$, where $\omega$ is the frequency of the fundamental signal Vraw. The resulting compensation, the signal Vcal (represented by a signal 154, 155, 157, 159), compensates intermodulation without affecting the harmonic distortion. For example, only fundamental portion 154, 155 of the signal Vraw and intermodulated distorted portions 157, 159 are present, but no harmonic distortion is in the calibration signal Veal (e.g., calibration voltage).

Calibration voltage refers to a known and constant voltage that is used to calibrate or adjust electrical devices. Calibration voltage may be generated by a stable and precise voltage source such as a voltage divider, zener diode, or precision voltage reference. Electrical devices can drift or lose accuracy over time due to factors such as temperature changes, aging, and wear and tear. Calibration voltage is used to adjust the device internal circuitry and correct errors or offsets that have occurred over time.

When measuring the semiconductor chip implementing the systems 100, 700, the two-tone IMD3 test can identify significant linearity performance differences between data captured by the RF band circuit 106 and baseband circuit 102. The two-tone test comparison in the RF and baseband data can illustrate the methods described herein for linearity IMD3 improvement in the baseband circuit 102. If only non-linearity intermodulation tones improve in the baseband circuit 102, but other tones do not, it may indicate that the non-linearity compensation is performed in the baseband circuit 102.

When the tests for one-tone (FIG. 2) and two-tone signals (FIG. 3) are compared, the compensation performed by the system 100 using the baseband compensation methods compensates only a two-tone signal or intermodulation tones without affecting the test results of harmonic tones or the one-tone signal.

The system 100 provides advantages over analog or RF band compensation methods which do not differentiate between harmonic and intermodulation. Such lack of differentiation can result in conflict compensation because harmonic and intermodulation distortions may be not correlated.

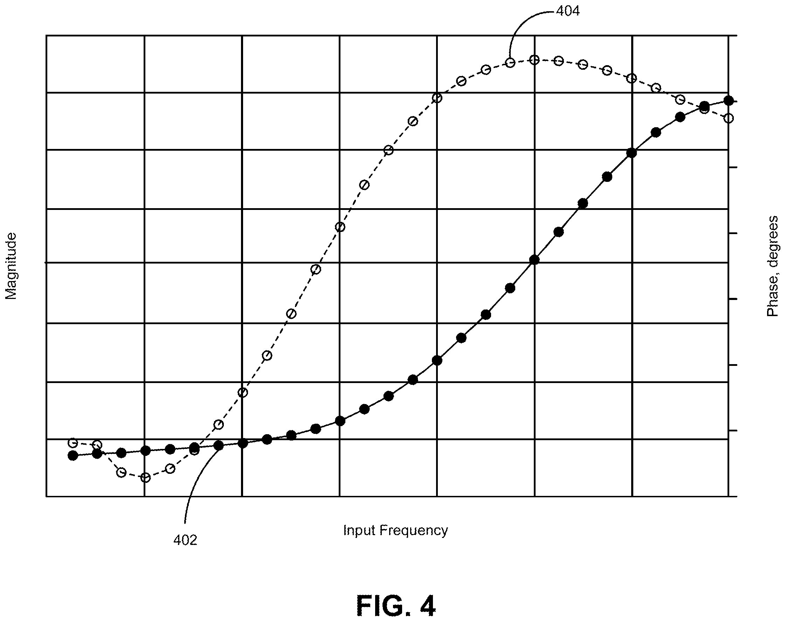

FIG. 4 illustrates a magnitude 402 and a phase 404 of the non-linearity coefficient a3 for different frequencies, according to some embodiments. Receiver non-linearity is characterized by the non-linearity coefficient, a3, as shown previously in FIG. 1. Over frequency, the coefficient a3 has variation in magnitude 402 and phase 404, as shown in FIG. 4. However, this variation the coefficient a3 is at least partially restricted over PVT and external conditions of live implementations. Voltage and temperature environment changes can be tracked and factored into values of the coefficient a3 to adjust and apply the coefficient a3 under given PVT and external conditions.

Having the magnitude 402 and the phase 404, the coefficient a3 is a complex number, which can be implemented in the digital baseband circuitry 102. A complex number is a type of number that combines a real number and an imaginary number. It is written in the form a + jb, where "a" is the real part and "bj" is the imaginary part. The letter "j" represents the square root of minus one. Complex numbers enable solutions of equations that involve negative roots. The real part of a complex number represents the horizontal position on the complex plane, while the imaginary part represents the vertical position. The complex plane is a two-dimensional graph where the horizontal axis represents the real numbers, and the vertical axis represents the imaginary numbers. Complex numbers can be added, subtracted, multiplied, and divided as real numbers.

Having a readily available and relatively straightforwardly implemented in the digital baseband circuitry 102 is advantageous over an RF band non-linearity compensation which often require high orders of compensation terms to correct for the changed phase of the intermodulation. In some embodiments, a data structure, such as a database, e.g., a look-up table (LUT) with preset values of the coefficient a3 that are collected through measurement of the coefficient a3 for different frequencies. Based on the RF operating frequency band, the coefficient a3 can be programmed to have a value at the corresponding frequency. Then, such values of the coefficient a3 can be applied when the given RF operating frequency band is used.

Operational (or operating) frequency refers to the frequency at which an electronic device or system operates. It is the measure of the number of cycles per second or Hertz (Hz) at which a device or system performs its intended function. The operational frequency of a device or system depends on its underlying technology, design, and intended use.

Test frequency refers to the frequency at which an electronic device, circuit or system is tested for its functionality or performance. The test frequency is determined by various factors such as the intended use of the electronic device, the importance of its operation, and any desired performance characteristics. Testing at higher frequencies can also help detect faults or defects that may not be detectable at lower frequencies.

A database is a structured collection of data that is organized in a way that allows easy access, retrieval, and management of data. The database is a digital repository that stores, organizes, and manages data in a systematic manner. In a database, data is stored in tables, which can represent virtual containers that contain related data. Each table can contain rows and columns, which represent individual records and fields, respectively. With the use of queries, reports, and forms, users can extract useful information from the database without having to manually sort through large amounts of data.

A lookup table (LUT) is a data structure commonly used in computer programs to efficiently retrieve information based on a key. The LUT is a table where each row contains a key-value pair, where one column contains the keys, and another column contains the corresponding values. The key is used to look up the corresponding value in the table. The lookup table is created beforehand and stored in memory, allowing for fast and efficient access to the information when needed. The LUT can be used in scenarios where the same data is accessed repeatedly, as the LUT can significantly reduce the amount of computation used to retrieve the information. The LUT can be implemented in various ways, including arrays, hash tables, and binary trees.

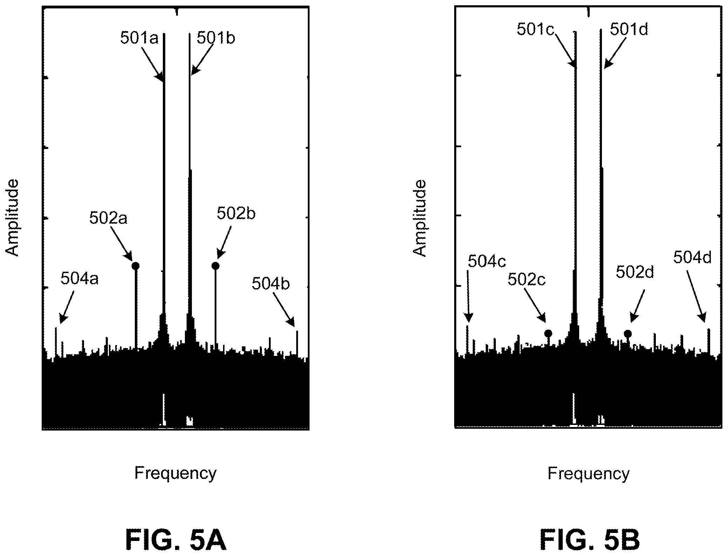

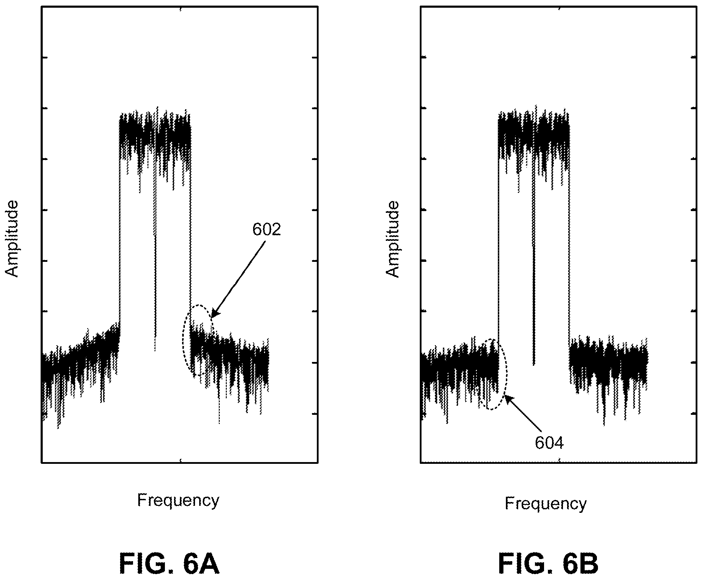

Figs. 5A-5B and 6A-6B illustrate a linearity performance improvement of the non-linearity compensation system 100, according to some embodiments. FIGS. 5A-5B illustrate a digital non-linearity compensation using a two-tone test. The two-tone test is one of the testing methods to evaluate receiver intermodulation. The two-tone test involves the analysis of a device response to two different input signals or frequencies. The setup often involves applying two sinusoidal signals of known frequencies and amplitudes to the device under test and then examining the output signal.

FIGS. 5A-5B illustrate results of a two-tone test using fast Fourier transform (FFT) of the receiver (RX) baseband (BB) signal. In some embodiments, the FFT or RX BB signal can have components of the following signals: a fundamental signal 501, intermodulation distortion 502, e.g., IMD3 (that includes the IMD and a third order component of the IMD), and noise signal 504. FIG. 5A illustrates the test results before the digital linearity compensation by the system 100. FIG. 5B illustrates the test results after the compensation by the system 100. FIGS. 5A-5B illustrate an improvement in component 502 associated with the IMD3 distortion. For example, the IMD3 significantly improves after performing the digital linearity compensation using the system 100. In FIG. 5A, the IMD3 components 502a, 502b before the digital linearity compensation is above the noise signal 504a, 504b. In FIG. 5B, the IMD3 components 502c, 502d after the digital linearity compensation is below the noise signal 504c, 504d. Such digital linearity compensation enables less distortion, by the improved IMD3 components 502c, 502d, of the fundamental signals 501c, 501d. For example, the fundamental signals 501c, 501d are more discernible in comparison to the fundamental signals 501a, 501b because 501a, 501b are more distorted by the IMD3 components 502a, 502b before the digital linearity compensation is performed using the system 100.

FIGS. 6A-6B illustrate a digital non-linearity compensation using a wide-band simulation. For the wide-band simulation, a frequency range can be defined, then a reliable signal source can be selected to operate within the defined frequency range, e.g., signal generators or RF sources can be used. The weak signals can be amplified if necessary, using high-quality, low-noise amplifiers. Signal conditioning elements, such as filters and attenuators, can be used for signal preparation. High-performance spectrum analyzers or oscilloscopes with wide bandwidth capabilities can be used for accurate signal analysis.

FIG. 6A illustrates the results of the wide-band simulation before compensation. FIG. 6B illustrates the results of the wide-band simulation after compensation. The wide-band simulation illustrates skirts 602, 604. The term "skirt" refers to the gradual, sloping regions surrounding the main signals in an amplitude versus frequency graphs in FIGS. 6A-6B. The sloping areas can be referred to as "side lobes" or "skirts." The skirts represent the signal amplitudes at frequencies adjacent to the main signal frequency. The skirt can show a gradual decrease in amplitude as you move away from the central frequency. The presence of the spurious frequencies caused by IMD, along with the different amplitudes and phases of the spurious frequencies, can modify the overall shape of the skirts. The skirts may become more irregular, exhibiting deviations from the ideal response that has relatively flat skirts.

In FIGS. 6A-6B, the wideband simulation shows the received data has the lesser slope of the skirt 604 after compensation than the slope of the skirt 602 that the signal has before compensation (e.g., the compensation by the system 100 relatively flattens the skirt 602). Having the lesser slope of the skirt 604 is attributed to mitigating, by the system 100, an effect from intermodulation non-linearity.

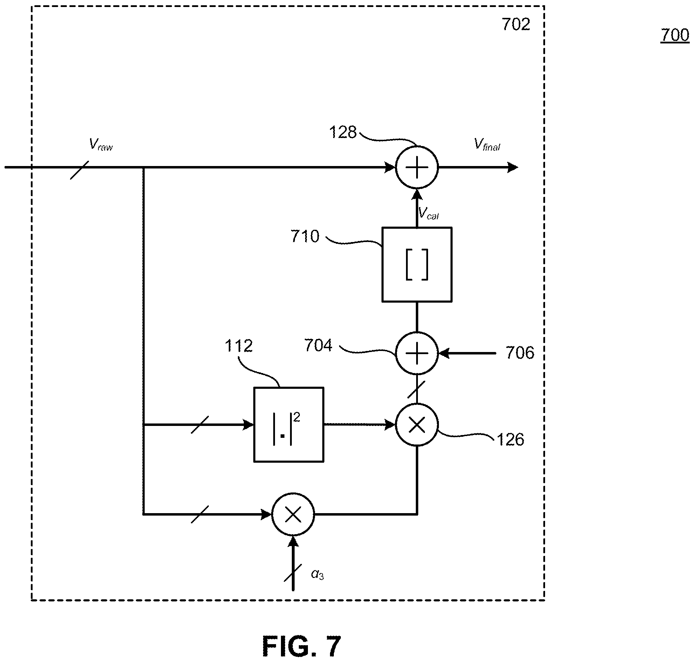

FIG. 7 illustrates a digital baseband non-linearity compensation system 700 having a dither 706 and rounding or truncation operation 710. For the live digital implementations of the system 700, the dither 706 is added through an addition operator 704 in a baseband circuit 702 before rounding or truncation operator 710.

A rounding or truncation engine (module or operator) is a hardware, firmware, or software component that is responsible for performing rounding or truncation operations on numerical data. Rounding involves converting a number to the nearest integer or decimal point, while truncation involves removing the decimal portion of a number. The truncation and rounding operations can be implemented as software functions or libraries that can be accessed by other programs. These engines can incorporate various rounding or truncation algorithms, such as round up, round down, and round to nearest, to provide different options for users. Additionally, these engines may have various configuration parameters that allow users to customize the rounding or truncation behavior.

The spurious signals result from the quantization process in analog-to-digital converters (ADCs). When an analog signal is converted into a digital format, the analog signal divided into discrete levels or quantization intervals. The quantization process introduces error, and this error leads to quantization noise, which includes quantization spurs. The quantization spurs manifest as unwanted spectral components in the frequency domain. The quantization spurs appear at predictable intervals in the spectrum, for example, at multiples of the sampling frequency.

The term "dither" refers to a type of noise that is added to a digital signal to reduce distortion and increase resolution. The dither noise is a randomized pattern of bits that can be added to the least significant bits of a digital signal, allowing for a smoother and more accurate representation of the original signal. In addition to reducing distortion and increasing resolution, dithering can also help to mask other types of noise that may be present in a digital signal. By adding random noise to the signal, dithering can hide other types of noise that may be introduced during processing or transmission.

As a small amount of random noise, the dither 706 can be added to the signal before rounding or truncation 710. The dither noise 706, effectively performs a frequency-domain dispersion ("smearing out") of the quantization error over a broader frequency range. For example, the dither 706 is added to mitigate quantization spurs, when e.g., the input signal Vraw is relatively small and at the boundary of rounding or truncation minimum level. The multi-bit dither 706 is illustrated in FIG. 7 to remove the quantization spur signal, e.g., making the quantization spur signals below a noise floor.

In some embodiments, a combination of the digital baseband non-linearity compensation engine 104 (FIG. 1), the multiplicators 112, 126, 127, the addition operator 128, the addition operator 704 where the dither 706 is added, and the truncation or rounding operator 710 can refer to as a compensator.

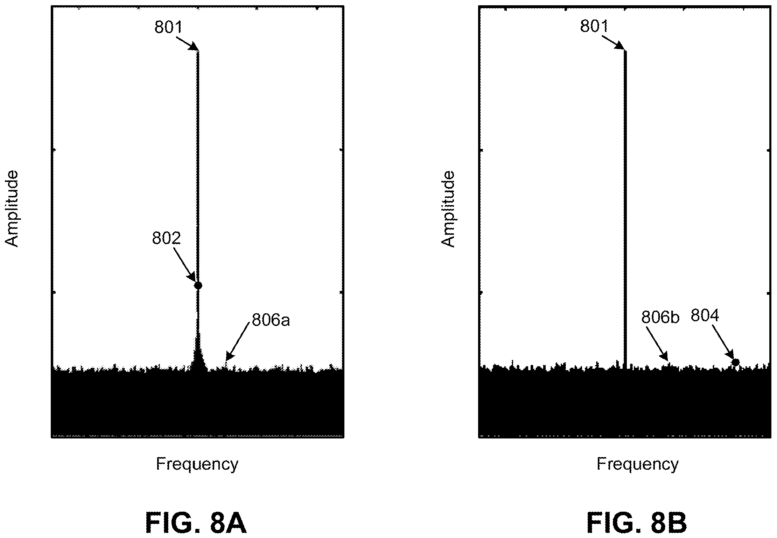

FIG. 8A illustrates an output of the digital baseband non-linearity compensation system 700 without adding the dither 706. For example, a quantization spur signal 802 can have an amplitude higher than a noise level represented by, e.g., amplitude 806a.In some embodiments, the amplitude of the quantization spur signal 802 can be comparable to an amplitude of the incoming signal 801 (e.g., quantization spur 802 can be near the incoming signal 801). FIG. 8B illustrates an output of the digital baseband non-linearity compensation system 700 when the dither 706 is added. After adding the dither 706, the quantization spur signal 804 is moved, by the dither 706, below the noise floor where the noise floor can be represented, e.g., by the amplitude 806b.

The systems 100, 700 can provide low power consumption and high performance. In some embodiments, the digital baseband non-linearity compensation can save significant power and improve linearity performance compared with the analog or RF band non-linearity compensation. The digital non-linearity compensation can compensate the non-linearity of the entire receiver path without negatively affecting the other receiver performance such as noise mitigation. The systems 100, 700 have significant linearity improvement in comparison to other non-linearity compensation systems. For example, improved linearity performance can be used in wireless basestations.

In some embodiments, utilizing the systems 100, 700 can eliminate analog non-linearity compensation or digital RF band compensation. Compared with the RF band non-linearity compensation, the digital baseband non-linearity compensation has significant power and area advantage. The overall systems 100, 700 can be more compact. Since the linearity of the receiver front-end of the systems 100, 700 can be significantly improved, more flexibility can be achieved. For example, traded-off for other performance in certain application scenarios, such as trading less linearity improvement with more noise performance can be achieved in the systems 100, 700.

In some embodiments, the semiconductor chip implementing the systems 100, 700 may have a knob to enable and disable the digital compensation in the chip. A difference between the two results (with and without the digital compensation) can be derived enabling and disabling the digital compensation. A corrective term or calibrating term $V_{cal}$ can be identified that can include a result of multiplication of $V_{raw}$ by $|V_{raw}|^2$, e.g., the

component $(I+j\times Q)\times|I+j\times Q|^2$.

When the semiconductor chip implementing the systems 100, 700 is de-capped, the digital baseband processing block at the receiver side can be enlarged due to an additional block performing the non-linearity correction in the baseband circuitry 102. In some embodiments, the direct-sampling basestation receiver implementing the systems 100, 700, utilizing digital non-linearity compensation methods described herein, can be used in advanced complementary metal-oxide semiconductor (CMOS) technology and in new 5G, 6G, and Next-G wireless standards. The configuration of the systems 100, 700 can be applied to other direct-sampling based basestation receivers.

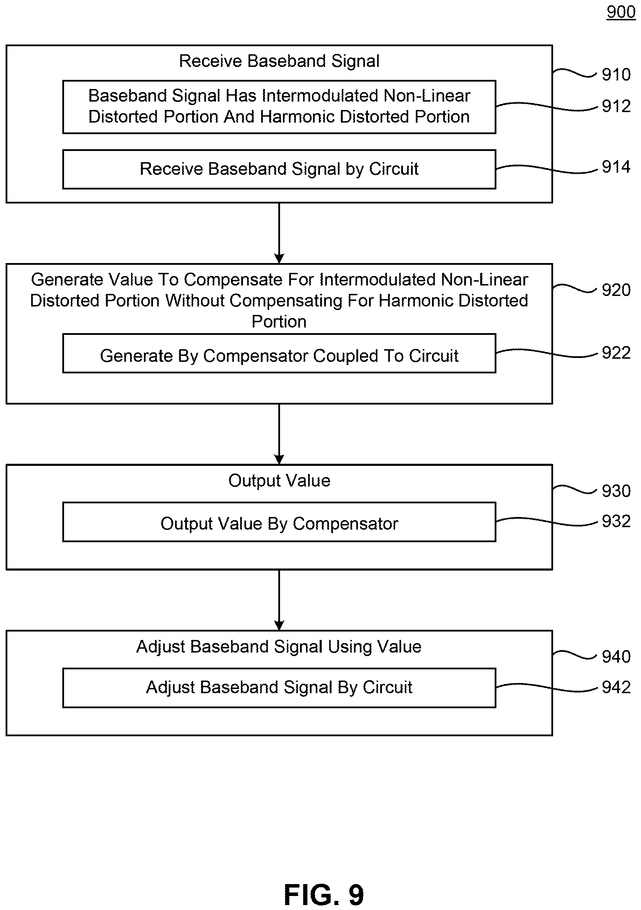

Fig. 9 is a flowchart of an example process 900. In some implementations, one or more process blocks of Fig. 9 may be performed by a system 100, 700.

As shown in Fig. 9, process 900 may include receiving a baseband signal, according to some embodiments (block 910). In some embodiments, the baseband signal has an intermodulated non-linear distorted portion and a harmonic distorted portion (block 912). In some embodiments, the baseband signal can be received by a circuit (block 914). For example, system 100, 700 may receive a baseband signal, by a circuit, where the baseband signal has an intermodulated non-linear distorted portion and a harmonic distorted portion, as described above.

As also shown in Fig. 9, process 900 may include generating a value to compensate for the intermodulated non-linear distorted portion without compensating for the harmonic distorted portion (block 920). In some embodiments, a compensator coupled to the circuit can generate the value (block 922). For example, system 100, 700 may generate, by a compensator coupled to the circuit, a value to compensate for the intermodulated non-linear distorted portion without compensating for the harmonic distorted portion, as described above.

As further shown in Fig. 9, process 900 may include outputting the value (block 930). In some embodiments, the compensator can output the value (block 932). For example, system 100, 700 may output, by the compensator, the value, as described above. As also shown in Fig. 9, process 900 may include adjusting the baseband signal using the value (block 940). In some embodiments, the circuit can adjust the baseband signal (block 942). For example, system 100, 700 may adjust, by the circuit, the baseband signal using the value, as described above.

Although Fig. 9 shows example blocks of process 900, in some implementations, process 900 may include additional blocks, fewer blocks, different blocks, or differently arranged blocks than those depicted in Fig. 9. In some implementations, two or more of the blocks of process 900 may be performed in parallel.

The following IEEE standard(s), including any draft versions of such standard(s), are hereby incorporated herein by reference in their entirety and are made part of the present disclosure for all purposes: IEEE 802.3, IEEE 802.11x, IEEE 802.11ad, IEEE 802.11ah, IEEE 802.11aj, IEEE 802.16 and 802.16a, and IEEE 802.11ac. In addition, although this disclosure may reference aspects of these standard(s), the disclosure is in no way limited by these standard(s).

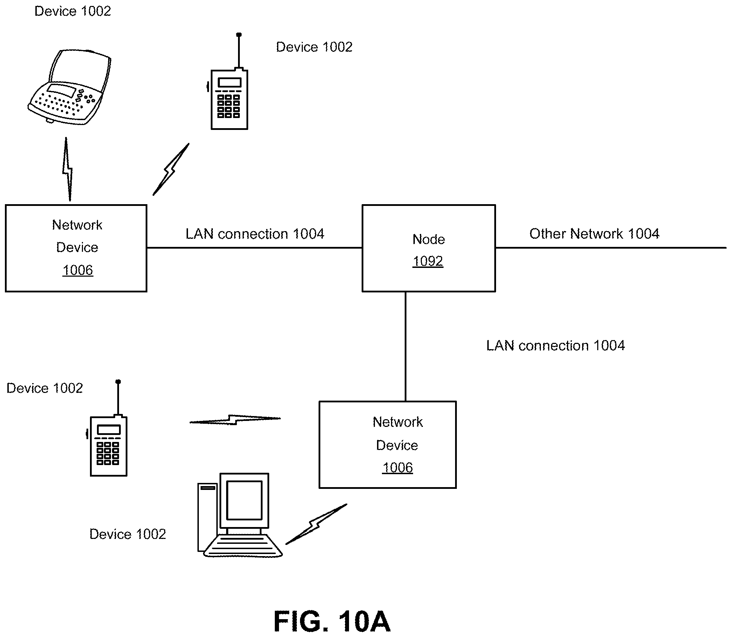

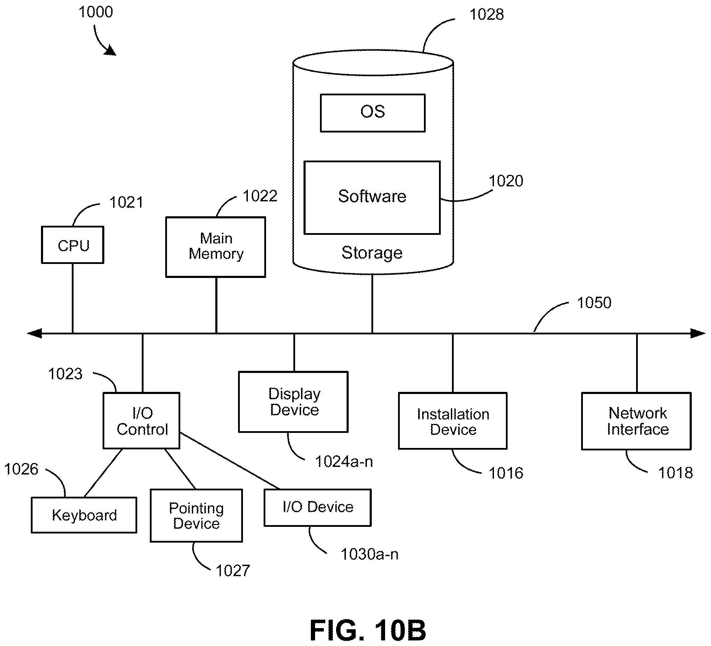

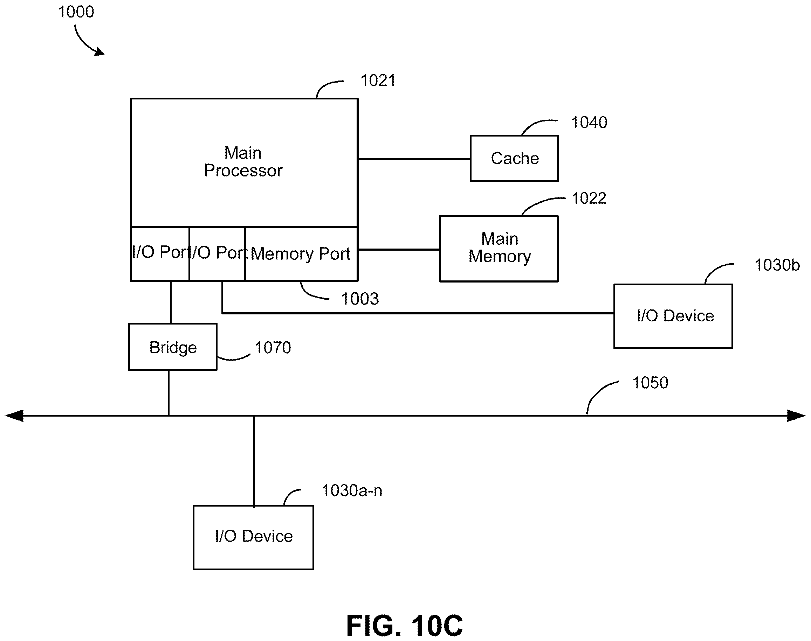

Having discussed specific embodiments of the present solution, it may be helpful to describe aspects of the operating environment as well as associated system components (e.g., hardware elements) in connection with the methods and systems described herein. Referring to FIG. 10A, an embodiment of a network environment is depicted. The network may include or be in communication with one or more storage area networks (SANs), security adapters, or Ethernet converged network adapters (CNAs). In brief overview, the network environment includes a communication system that includes one or more network devices 1006, one or more client devices 1002 and a network hardware component 1092. In some embodiments, the network device 1006 can be an access point (AP). In some embodiments, the client device 1002 can be a wireless communication device. For example, the client devices 1002 may include laptop computers 1002, tablets 1002, personal computers 1002, wearable devices 1002, vehicles 1002 (e.g., automobiles, drones, smart vehicles, robotic units, and the like), video game consoles 1002, cellular telephone devices 1002, smart TV sets 1002, Internet of Thing (IoT) devices 1002, and any other electronic devices 1002 capable of wireless communication. The details of an embodiment of client devices 1002 and network device 1006 are described in greater detail with reference to FIGS. 10B and 10C. The network environment can be an ad hoc network environment, an infrastructure wireless network environment, a wired network coupled to a wireless network, a subnet environment, or a combination of the foregoing, in one embodiment.

The term "coupled," and variations thereof includes the joining of two members directly or indirectly to one another. The term "electrically coupled" and variations thereof includes the joining of two members directly or indirectly to one another through conductive materials (e.g., metal or copper traces). Such joining may be stationary (e.g., permanent or fixed) or moveable (e.g., removable or releasable). Such joining may be achieved with the two members coupled directly with or to each other, with the two members coupled with each other using a separate intervening member and any additional intermediate members coupled with one another, or with the two members coupled with each other using an intervening member that is integrally formed as a single unitary body with one of the two members. If "coupled" or variations thereof are modified by an additional term (e.g., directly coupled), the generic definition of "coupled" provided above is modified by the plain language meaning of the additional term (e.g., "directly coupled" means the joining of two members without any separate intervening member), resulting in a narrower definition than the generic definition of "coupled" provided above. Such coupling may be mechanical, electrical, or fluidic.

The network devices 1006 may be operably coupled to the network hardware 1092 via local area network connections. The network hardware 1092, which may include one or more routers, gateways, switches, bridges, modems, system controllers, appliances, and the like, may provide a local area network connection for the communication system. Each of the network devices 1006 may have an associated antenna or an antenna array to communicate with the client devices in its area. The client devices may register with a particular network device 1006 to receive services from the communication system (e.g., via a SU-MIMO or MU-MIMO configuration). For direct connections (i.e., point-to-point communications), some client devices may communicate directly via an allocated channel and communications protocol. Some of the client devices 1002 may be mobile or relatively static with respect to the network device 1006.

In some embodiments, a network device 1006 includes a device or module (including a combination of hardware and software) that enables the connection of client devices 1002 to wired or wireless networks. The network device 1006 is oriented towards wired connections and is designed to support wireless connections. The configuration and design of the network device 1006 enables communication of the network device 1006 with controllers and storage devices established through wired links. A network device 1006 may connect to a router (e.g., via a wired network) as a standalone device in some embodiments. In other embodiments, a network device 1006 can be a component of a router. A network device 1006 can provide multiple devices access to a network. A network device 1006 may, for example, connect to a wired Ethernet connection and provide wireless connections using radio frequency links for other devices 1002 to utilize that wired connection. A network device 1006 may be built and configured to support a standard for sending and receiving data using one or more radio frequencies. Those standards and the frequencies they use may be defined by the IEEE (e.g., IEEE 802.11 standards). A network device 1006 may be configured and used to support public Internet hotspots and on an internal network to extend the network's Wi-Fi signal range.

In some embodiments, the network devices 1006 may be used for in-home or in-building wireless networks (e.g., IEEE 802.11, Bluetooth, ZigBee, any other type of radio frequency-based network protocol or variations thereof). Each of the client devices 1002 may include a built-in radio or be coupled to a radio. Such client devices 1002 and network devices 1006 may operate in accordance with the various aspects of the disclosure as presented herein to enhance performance, reduce costs or size, and enhance broadband applications. Each client device 1002 may have the capacity to function as a client node seeking access to resources (e.g., data, and connection to networked nodes such as servers) via one or more network devices.

The network connections may include any type or form of network and may include any of the following: a point-to-point network, a broadcast network, a telecommunications network, a data communication network, or a computer network. The topology of the network may be a bus, star, or ring network topology. The network may be of any such network topology as known to those ordinarily skilled in the art and capable of supporting the operations described herein. In some embodiments, different types of data may be transmitted via different protocols. In other embodiments, the same types of data may be transmitted via different protocols.

The client device(s) 1002 and network device(s) 1006 may be deployed as or executed on any type and form of computing device, such as a computer, network device, or appliance capable of communicating on any type and form of network and performing the operations described herein. FIGS. 10B and 10C depict block diagrams of a computing device 1000 useful for practicing an embodiment of the client device 1002 or network device 1006. As shown in FIGS. 10B and 10C, each computing device 1000 includes a central processing unit 1021, and a main memory or main memory unit 1022. As shown in FIG. 10B, a computing device 1000 may include a storage device 1028, an installation device 1016, a network interface 1018, an I/O controller 1023, display devices 1024a-1024n, a keyboard 1026 and a pointing device 1027, such as a mouse. The storage device 1028 may include, without limitation, an operating system or software. As shown in FIG. 10C, each computing device 1000 may also include additional optional elements, such as a memory port 1003, a bridge 1070, one or more input/output (I/O) devices 1030a-1030n (generally referred to using reference numeral 1030), and a cache memory 1040 in communication with the central processing unit 1021.

A circuit is a network of interconnected electronic components, such as resistors, capacitors, inductors, and transistors, that work together to perform a specific function. The components are connected in a specific way to enable the flow of electricity through the circuit, allowing it to perform its intended task. "Circuitry" can refer to the interconnected arrangement of electronic components and pathways that allow the flow of electrical signals within a device, system, or application. In some embodiments, a single component circuitry can be an electronic component such as a resistor, capacitor, or transistor that performs a certain function within an electronic system. In some embodiments, multiple components working together in circuitry can include coordination of various electronic components. In some embodiments, the circuitry can include hardware components, such as integrated circuits, transistors, resistors, capacitors, and connectors, as well as combinations of hardware and software or firmware elements that can operate together to perform various functions. The multiple components can include separate components such as sensors, microcontrollers, memory modules, communication interfaces, or power management circuits, which are interconnected to form a functional system. For example, the circuitry can include microcontrollers or processors that execute software instructions to control the behavior of the hardware components. For example, the circuitry processors can run programs that enable the device or system to perform various tasks such as data processing and communication. In some embodiments, the components may not be physically contained within the same device, for example, the components can be distributed across different devices connected through wired or wireless interfaces.

The central processing unit (CPU) 1021 is any logic circuitry that responds to and processes instructions fetched from the main memory unit 1022. In many embodiments, the central processing unit 1021 is provided by a microprocessor unit, such as those manufactured by Intel Corporation of Mountain View, California; those manufactured by International Business Machines of White Plains, New York; or those manufactured by Advanced Micro Devices of Sunnyvale, California. The computing device 1000 may be based on any of these processors or any other processor capable of operating as described herein. The CPU can be a programmable parallel processor.

Other programmable parallel processors can include a graphics processing unit (GPU) and a neural processor. The GPU is a programmable parallel processor that can perform complex computations for graphics rendering and general-purpose computing tasks. The GPU consists of processing cores interconnected through a high-bandwidth memory interface and a bus system, enabling efficient parallel processing. The processing core of the GPU can be equipped with dedicated arithmetic logic units and memory caches, allowing for simultaneous execution of multiple computational threads. To optimize graphics rendering pipelines, the GPU can incorporate the following hardware components: texture units and rasterizers. The GPU can employ optimized algorithms and data parallelism techniques to accelerate computations, resulting in superior performance compared to a conventional CPU. The GPU can be programmable using graphics application programming interfaces (APIs) and parallel computing frameworks, enabling scientific simulations, machine learning, and data analytics.

Main memory unit 1022 may be one or more memory chips capable of storing data and allowing any storage location to be accessed by the microprocessor 1021, such as any type or variant of Static random-access memory (SRAM), Dynamic random-access memory (DRAM), Ferroelectric RAM (FRAM), NAND Flash, NOR Flash and Solid-State Drives (SSD). The main memory 1022 may be based on any of the above-described memory chips, or any other available memory chips capable of operating as described herein. In the embodiment shown in FIG. 10B, the processor 1021 communicates with main memory 1022 via a system bus 1050 (described in more detail below). FIG. 10C depicts an embodiment of a computing device 1000 in which the processor communicates directly with main memory 1022 via a memory port 1003. For example, in FIG. 10C the main memory 1022 may be DRAM.

FIG. 10C depicts an embodiment in which the main processor 1021 communicates directly with cache memory 1040 via a secondary bus, sometimes referred to as a backside bus. In other embodiments, the main processor 1021 communicates with cache memory 1040 using the system bus 1050. Cache memory 1040 typically has a faster response time than main memory 1022 and is provided by, for example, SRAM, BSRAM, or EDRAM. In the embodiment shown in FIG. 10C, the processor 1021 communicates with various I/O devices 1030 via a local system bus 1050. Various buses may be used to connect the central processing unit 1021 to any of the I/O devices 1030, for example, a VESA VL bus, an ISA bus, an EISA bus, a MicroChannel Architecture (MCA) bus, a PCI bus, a PCI-X bus, a PCI-Express bus, or a NuBus. For embodiments in which the I/O device is a video display 1024, the processor 1021 may use an Advanced Graphics Port (AGP) to communicate with the display 1024. FIG. 10C depicts an embodiment of a computer or computer system 1000 in which the main processor 1021 may communicate directly with I/O device 1030b, for example via HYPERTRANSPORT, RAPIDIO, or INFINIBAND communications technology. FIG. 10C also depicts an embodiment in which local busses and direct communication are mixed: the processor 1021 communicates with I/O device 1030a using a local interconnect bus while communicating with I/O device 1030b directly.

A wide variety of I/O devices 1030a-1030n may be present in the computing device 1000. Input devices include keyboards, mice, trackpads, trackballs, microphones, dials, touch pads, touch screen, and drawing tablets. Output devices include video displays, speakers, inkjet printers, laser printers, projectors and dye-sublimation printers. The I/O devices may be controlled by an I/O controller 1023 as shown in FIG. 10B. The I/O controller may control one or more I/O devices, such as a keyboard 1026 and a pointing device 1027, e.g., a mouse or optical pen. Furthermore, an I/O device may also provide storage and an installation medium 1016 for the computing device 1000. In still other embodiments, the computing device 1000 may provide USB connections (not shown) to receive handheld USB storage devices such as the USB Flash Drive line of devices manufactured by s Industry, Inc., of Los Alamitos, California.

Referring again to FIG. 10B, the computing device 1000 may support any suitable installation device 1016, such as a disk drive, a CD-ROM drive, a CD-R/RW drive, a DVD-ROM drive, a flash memory drive, tape drives of various formats, USB device, hard-drive, a network interface, or any other device suitable for installing software and programs. The computing device 1000 may further include a storage device, such as one or more hard disk drives or redundant arrays of independent disks (storage devices), for storing an operating system and other related software, and for storing application software programs such as any program or software 1020 for implementing (e.g., software 1020 configured or designed for) the systems and methods described herein. In some embodiments, any of the installation devices 1016 could be used as the storage device. In some embodiments, the operating system and the software can be run from a bootable medium.

Furthermore, the computing device 1000 may include a network interface 1018 to interface to the network 1004 through a variety of connections including, but not limited to, standard telephone lines, LAN or WAN links (e.g., 802.11, T1, T3, 56kb, X.25, SNA, DECNET), broadband connections (e.g., ISDN, Frame Relay, ATM, Gigabit Ethernet, Ethernet-over-SONET), wireless connections, or some combination of any or all of the above. Connections can be established using a variety of communication protocols (e.g., TCP/IP, IPX, SPX, NetBIOS, Ethernet, ARCNET, SONET, SDH, Fiber Distributed Data Interface (FDDI), RS232, IEEE 802.11, IEEE 802.11a, IEEE 802.11b, IEEE 802.11g, IEEE 802.11n, IEEE 802.11ac, IEEE 802.11ad, CDMA, GSM, WiMax and direct asynchronous connections). In one embodiment, the computing device 1000 communicates with other computing devices 1000 via any type and form of gateway or tunneling protocol such as Secure Socket Layer (SSL) or Transport Layer Security (TLS). The network interface 1018 may include a built-in network adapter, network interface card, PCMCIA network card, card bus network adapter, wireless network adapter, USB network adapter, modem or any other device suitable for interfacing the computing device 1000 to any type of network capable of communication and performing the operations described herein.

In some embodiments, the computing device 1000 may include or be connected to one or more display devices 1024a-1024n. As such, any of the I/O devices 1030a-1030n and the I/O controller 1023 may include any type or form of suitable hardware, software, or combination of hardware and software to support, enable or provide for the connection and use of the display device(s) 1024a-1024n by the computing device 1000. For example, the computing device 1000 may include any type or form of video adapter, video card, driver, and library to interface, communicate, connect or otherwise use the display device(s) 1024a-1024n. In one embodiment, a video adapter may include multiple connectors to interface to the display device(s) 1024a-1024n. In other embodiments, the computing device 1000 may include multiple video adapters, with each video adapter connected to the display device(s) 1024a-1024n. In some embodiments, any portion of the operating system of the computing device 1000 may be configured for using multiple displays 1024a-1024n. One ordinarily skilled in the art will recognize and appreciate the various ways and embodiments that a computing device 1000 may be configured to have one or more display devices 1024a-1024n.

In further embodiments, an I/O device 1030 may be a bridge between the system bus 1050 and an external communication bus, such as a USB bus, an Apple Desktop Bus, an RS-232 serial connection, a SCSI bus, a FireWire bus, a FireWire 1000 bus, an Ethernet bus, an AppleTalk bus, a Gigabit Ethernet bus, an Asynchronous Transfer Mode bus, a FibreChannel bus, a Serial Attached small computer system interface bus, a USB connection, or a HDMI bus.

A computing device or system 1000 of the sort depicted in FIGS. 10B and 10C may operate under the control of an operating system, which controls scheduling of tasks and access to system resources. The computing device 1000 can be running any operating system, such as any of the versions of the MICROSOFT WINDOWS operating systems, the different releases of the Unix and Linux operating systems, any version of the MAC OS for Apple computers, any embedded operating system, any real-time operating system, any open source operating system, any proprietary operating system, any operating systems for mobile computing devices, or any other operating system capable of running on the computing device and performing the operations described herein. Typical operating systems include, but are not limited to, Android, produced by Google Inc.; WINDOWS 7 and 8, produced by Microsoft Corporation of Redmond, Washington; MAC OS, produced by Apple Computer of Cupertino, California; WebOS, produced by Research In Motion (RIM); OS/2, produced by International Business Machines of Armonk, New York; and Linux, a freely-available operating system distributed by Caldera Corp. of Salt Lake City, Utah, or any type and form of a Unix operating system, among others.

The computer system 1000 can be any networking device, storage device, workstation, telephone, desktop computer, laptop or notebook computer, server, handheld computer, mobile telephone or other portable telecommunications device, media playing device, a gaming system, mobile computing device, or any other type or form of computing, telecommunications or media device that is capable of communication. The computer system 1000 has sufficient processor power and memory capacity to perform the operations described herein.

In some embodiments, the computing device 1000 may have different processors, operating systems, and input devices consistent with the device. For example, in one embodiment, the computing device 1000 is a smart phone, mobile device, tablet or personal digital assistant. In still other embodiments, the computing device 1000 is an Android-based mobile device, an iPhone smart phone manufactured by Apple Computer of Cupertino, California, or a Blackberry or WebOS-based handheld device or smart phone, such as the devices manufactured by Research In Motion Limited. Moreover, the computing device 1000 can be any workstation, desktop computer, laptop or notebook computer, server, handheld computer, mobile telephone, any other computer, or other form of computing or telecommunications device that is capable of communication and that has sufficient processor power and memory capacity to perform the operations described herein. Aspects of the operating environments and components described above will become apparent in the context of the systems and methods disclosed herein.

It should be noted that certain passages of this disclosure can reference terms such as "first" and "second" in connection with devices signals, data, inputs, channels, and the like for purposes of identifying or differentiating one from another or from others. These terms are not intended to merely relate entities (e.g., a first input and a second input) temporally or according to a sequence, although in some cases, these entities can include such a relationship, nor do these terms limit the number of possible entities (e.g., devices) that can operate within a system or environment.

It should be understood that the systems described above can provide multiple ones of any or each of those components. In addition, the systems and methods described above can be provided as one or more computer-readable programs or executable instructions, programmable circuits, or digital logic embodied on or in one or more articles of manufacture. The article of manufacture can be a floppy disk, a hard disk, a CD-ROM, a flash memory card, a PROM, a RAM, a ROM, ASIC, or a magnetic tape. In general, the computer-readable programs can be implemented in any programming language, such as LISP, PERL, C, C++, C#, PROLOG, or in any byte code language such as JAVA. The software programs or executable instructions can be stored on or in one or more articles of manufacture as object code.

While the foregoing written description of the methods and systems enables one of ordinary skill to make and use various embodiments of these methods and systems, those of ordinary skill will understand and appreciate the existence of variations, combinations, and equivalents of the specific embodiment, method, and examples herein. The present methods and systems should therefore not be limited by the above-described embodiments, methods, and examples, but by all embodiments and methods within the scope and spirit of the disclosure.

**Claims**

1. A circuitry comprising:

   a circuit configured to receive a baseband signal, the baseband signal having an intermodulated non-linear distorted portion and a harmonic distorted portion; and
   a compensator coupled to the circuit, the compensator configured to generate a value to compensate for the intermodulated non-linear distorted portion without compensating for the harmonic distorted portion,
   wherein the compensator is configured to output the value, and
   wherein the circuit is configured to adjust the baseband signal using the value.

2. The circuitry of claim 1, wherein the baseband signal is a baseband voltage.

3. The circuitry of claim 1 or 2, wherein the value is a complex number further comprising an in-phase portion of the baseband signal and a quadrature portion of the baseband signal.

4. The circuitry of any preceding claim, wherein the compensator further comprises:

   at least one of a rounding or truncation engine to output the value,
   wherein the value is rounded or truncated, and
   wherein a dither is injected before the rounding or truncation engine.

5. The circuitry of any preceding claim, wherein the value is based at least on the baseband signal, a square of an absolute value of the baseband signal, and a non-linearity coefficient.

6. The circuitry of claim 5, wherein one or more values of the non-linearity coefficient are selected responsive to an operational frequency of the baseband signal.

7. The circuitry of any preceding claim, further comprising:
   a down converter to filter mirror frequencies.

8. A system comprising:
   a device configured to receive a baseband signal, the baseband signal having an intermodulated non-linear distorted portion and a harmonic distorted portion, the system comprising:

   a compensator configured to generate a value to compensate for the intermodulated non-linear distorted portion without compensating for the harmonic distorted portion,
   wherein the device is configured to adjust the baseband signal using the value provided by the compensator.

9. A method, comprising:

   receiving, by a circuit, a baseband signal, the baseband signal comprising an intermodulated non-linear distorted portion and a harmonic distorted portion;

generating, by a compensator coupled to the circuit, a value to compensate for the intermodulated non-linear distorted portion without compensating for the harmonic distorted portion; and

adjusting, by the circuit, the baseband signal using the value outputted by the compensator.

10. The method of claim 9, wherein the baseband signal is a baseband voltage.

11. The method of claim 9 or 10, wherein the value is a complex number further comprising an in-phase portion of the baseband signal and a quadrature portion of the baseband signal.

12. The method of any preceding claim 9 to 11, further comprising:

   injecting a dither to the compensator;
   at least one of rounding or truncating the value.

13. The method of any preceding claim 9 to 12, wherein the value is based at least on the baseband signal, a square of an absolute value of the baseband signal, and a non-linearity coefficient.

14. The method of claim 13, further comprising selecting one or more values of the non-linearity coefficient responsive to an operational frequency of the baseband signal.

15. The method of any preceding claim 9 to 14, further comprising:
   filtering, by a down converter, mirror frequencies from the baseband signal.

**FIG. 1**

FIG. 2

FIG. 3

FIG. 4

FIG. 5B

FIG. 5A

FIG. 6B

FIG. 6A

**FIG. 7**

EP 4 550 673 A1

FIG. 8B

FIG. 8A

24

900

Receive Baseband Signal — 910

Baseband Signal Has Intermodulated Non-Linear Distorted Portion And Harmonic Distorted Portion — 912

Receive Baseband Signal by Circuit — 914

Generate Value To Compensate For Intermodulated Non-Linear Distorted Portion Without Compensating For Harmonic Distorted Portion — 920

Generate By Compensator Coupled To Circuit — 922

Output Value — 930

Output Value By Compensator — 932

Adjust Baseband Signal Using Value — 940

Adjust Baseband Signal By Circuit — 942

**FIG. 9**

Device 1002

Device 1002

Network
Device
1006

LAN connection 1004

Node
1092

Other Network 1004

LAN connection 1004

Device 1002

Network
Device
1006

Device 1002

EP 4 550 673 A1

**FIG. 10A**

**FIG. 10B**

EP 4 550 673 A1

**FIG. 10C**

Europäisches
Patentamt

European
Patent Office

Office européen
des brevets

# EUROPEAN SEARCH REPORT

Application Number

EP 24 20 6460

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 1 954 491 A (ERICSSON TELEFON AB L M [SE]) 25 April 2007 (2007-04-25) <br><br> * paragraphs [0032], [0033], [0049]; claim 7; figure 9 * <br> - - - - - | 1-3, 5-11, 13-15 | INV. H04B1/12 |
| X | US 2019/123772 A1 (TU WEN-CHI [US] ET AL) 25 April 2019 (2019-04-25) | 1-3, 5-11, 13-15 | |
| Y | * paragraphs [0032], [0053] - [0058], [0081]; figure 4 * <br> - - - - - | 4,12 | |
| Y | US 2008/159453 A1 (SMITH FRANCIS J [US]) 3 July 2008 (2008-07-03) * paragraphs [0062], [0098]; figures 2A,2B,4,11 * <br> - - - - - | 4,12 | |

TECHNICAL FIELDS
SEARCHED      (IPC)

H04B

The present search report has been drawn up for all claims

| Place of search | Date of completion of the search | Examiner |
|---|---|---|
| Munich | 24 March 2025 | Marques, Gabriela |

EPO FORM 1503 03.82 (P04C01)

## ANNEX TO THE EUROPEAN SEARCH REPORT
## ON EUROPEAN PATENT APPLICATION NO.

EP 24 20 6460

This annex lists the patent family members relating to the patent documents cited in the above-mentioned European search report.
The members are as contained in the European Patent Office EDP file on
The European Patent Office is in no way liable for these particulars which are merely given for the purpose of information.

24-03-2025

| Patent document cited in search report | | Publication date | Patent family member(s) | | Publication date |
|---|---|---|---|---|---|
| CN 1954491 | A | 25-04-2007 | AT | E487272 T1 | 15-11-2010 |
| | | | CN | 1954490 A | 25-04-2007 |
| | | | CN | 1954491 A | 25-04-2007 |
| | | | EP | 1751851 A1 | 14-02-2007 |
| | | | EP | 1751852 A1 | 14-02-2007 |
| | | | US | 2007165745 A1 | 19-07-2007 |
| | | | US | 2007182484 A1 | 09-08-2007 |
| | | | WO | 2005112253 A1 | 24-11-2005 |
| | | | WO | 2005112254 A1 | 24-11-2005 |
| US 2019123772 | A1 | 25-04-2019 | US | 2016365883 A1 | 15-12-2016 |
| | | | US | 2019123772 A1 | 25-04-2019 |
| | | | US | 2020028533 A1 | 23-01-2020 |
| US 2008159453 | A1 | 03-07-2008 | EP | 1388229 A1 | 11-02-2004 |
| | | | US | 2003021367 A1 | 30-01-2003 |
| | | | US | 2008159453 A1 | 03-07-2008 |
| | | | US | 2012236976 A1 | 20-09-2012 |
| | | | WO | 02093807 A1 | 21-11-2002 |

EPO FORM P0459

For more details about this annex : see Official Journal of the European Patent Office, No. 12/82